# EUROPEAN PATENT APPLICATION

(11) **EP 4 800 802 A1**
(43) Date of publication of application: **02.09.2026**
(21) Application number: 25214002.5
(22) Date of filing: 06.11.2025
(51) Int. Cl.: H01M 10/48, H01M 50/284, H01M 50/298, H01M 50/519, H01M 10/42

(54) **BATTERY PACK**

(30) Priority: 28.02.2025 CN 202510237607
(71) Applicant: JINKO SOLAR CO., LTD, ShangRao, Jiangxi 334100 (CN); Zhejiang Jinko Energy Storage Co., Ltd., Jiaxing, Zhejiang (CN)
(72) Inventor: ZHANG, Luhua, Shangrao, 334100 (CN); SHI, Yanyan, Shangrao, 334100 (CN); LV, Yuanfu, Shangrao, 334100 (CN); CHEN, Yuanhang, Shangrao, 334100 (CN)
(74) Representative: DREISS Patentanwälte PartG mbB

(57) **Abstract**

Provided is a battery pack including at least two battery modules, a wiring harness for electrically connecting the battery modules and a battery management unit. The at least two battery modules include a first battery module directly electrically connected to the battery management unit. The battery module includes a cells contact system and battery cells. The first battery module includes a first circuit board. The first circuit board includes at least a first wiring layer and a second wiring layer. The first battery module of the battery pack is provided with at least two wiring layers, so that the battery pack transmits signals successively from the battery module with the farthest signal transmission distance to the battery management unit toward the battery module with a shorter signal transmission distance to the battery management unit, which facilitates reducing the length of the wiring harnesses and optimizing the arrangement of the wiring.

## Description

### TECHNICAL FIELD

The present disclosure relates to the field of energy storage technology and, in particular, to a battery pack.

### BACKGROUND

A battery pack is typically provided with a battery management system (BMS) and multiple battery modules. The BMS is configured to monitor and manages the operating status of the entire battery system in real time, thereby ensuring the safety and stability of the system. However, at present, each battery module needs to be directly electrically connected to the BMS individually through wiring harnesses, resulting in a messy wiring arrangement inside the battery pack.

### SUMMARY

One or more embodiments of the present disclosure provide a battery pack for solving the problem that each battery module needs to be electrically connected to the BMS individually through wiring harnesses, resulting in a messy wiring arrangement inside the battery pack.

One or more embodiments of the present disclosure provide a battery pack, including at least two battery modules and a wiring harness for electrically connecting the plurality of battery modules. The battery pack further includes a battery management unit, and the at least two battery modules include a first battery module directly electrically connected to the battery management unit. Each of the at least two battery modules includes a cells contact system and battery cells electrically connected to the cells contact system. The cells contact system includes a circuit board. The first battery module includes a first circuit board, and the first circuit board includes at least a first wiring layer and a second wiring layer. The first wiring layer is configured to transmit a signal of the first battery module to the battery management unit, and the second wiring layer is electrically connected to other battery modules adjacent to the first battery module, so that signals of other battery modules adjacent to the first battery module are transmitted to the battery management unit through the second wiring layer.

In technical solutions of the present disclosure, the first battery module of the battery pack is provided with at least two wiring layers, so that the battery pack transmits signals successively from the battery module with the farthest signal transmission distance to the battery management unit toward the battery module with a shorter signal transmission distance to the battery management unit, thereby finally transmitting the status information of the battery modules, except for the first battery module, to the battery management unit one by one through wiring layers, except for the first wiring layer, in the first battery module. Such a design avoids the problem in the conventional battery pack in which multiple battery modules are individually connected to the battery management unit through wiring harnesses, facilitates reduction of the length of the wiring harnesses used, and optimizing the arrangement of the wiring harness inside the battery pack, thereby improving the assembly efficiency inside the battery pack, reducing production costs, and improving the space utilization inside the battery pack.

In one or more embodiments of the present disclosure, the battery pack includes n battery modules, where n≥2. The first circuit board includes n wiring layers arranged along a thickness direction thereof.

In one or more embodiments of the present disclosure, the cells contact system further includes connectors. The cells contact system of the first battery module includes at least 2n-1 connectors. Each of the wiring layers of the first circuit board is electrically connected to at least one of the 2n-1 connectors.

In one or more embodiments of the present disclosure, each of circuit boards of at least part of the at least two battery modules includes n wiring layers arranged along a thickness direction thereof. Each of cells contact systems of at least part of the at least two battery modules includes at least 2n-1 connectors, and each of at least part of wiring layers of the circuit boards, except for the first circuit board, is electrically connected to at least one of the 2n-1 connectors.

In one or more embodiments of the present disclosure, the at least two battery modules further include a second battery module, and the second battery module is electrically connected to the battery management unit through all battery modules except for the second battery module. A second circuit board of the second battery module includes at least one wiring layer, and a cells contact system of the second battery module includes at least one connector, the at least one connector is electrically connected to the at least one wiring layer. Along a signal transmission direction from the second battery module to the battery management unit, a quantity of wiring layers of circuit boards of the at least two battery modules gradually increases, a quantity of connectors of cells contact systems of the at least two battery module gradually increases, and at least part of connectors of adjacent battery modules are electrically connected to each other.

In one or more embodiments of the present disclosure, along a length direction of the battery pack, each of the connectors is provided at an end of each of the at least two battery modules. Along the length direction of the battery pack, a plurality of connectors in the same battery module are arranged in a staggered manner.

In one or more embodiments of the present disclosure, the battery pack includes two battery modules, and the first battery module includes at least a first connector, a second connector, and a third connector. Along a thickness direction of the first circuit board, the first connector is provided at one side of the first circuit board, and the second connector and the third connector are provided at the other side of the first circuit board. The first connector is electrically connected to the first wiring layer, and the second connector and the third connector are electrically connected to the second wiring layer. The first connector and the second connector are electrically connected to the battery management unit through wiring harnesses corresponding thereto, respectively. The second circuit board includes at least a third wiring layer, and the second battery module includes at least a fourth connector. The third wiring layer is electrically connected to the fourth connector, and the fourth connector is electrically connected to the third connector through a wiring harness, so that a signal of the second battery module is transmitted to the battery management unit successively through the fourth connector, the third connector and the second connector.

In one or more embodiments of the present disclosure, the battery pack includes three battery modules. A third battery module that is electrically connected to the first battery module and the second battery module is provided between the first battery module and the second battery module, so that the first battery module and the second battery module transmit signals through the third battery module. The first circuit board further includes a fourth wiring layer, and the first battery module includes at least a first connector, a second connector, a third connector, a fifth connector and a sixth connector. Along a thickness direction of the first circuit board, the first connector is provided at one side of the first circuit board, the second connector, the third connector, the fifth connector and the sixth connector are provided at the other side of the first circuit board. The first connector is electrically connected to the first wiring layer, the second connector and the third connector are electrically connected to the second wiring layer, the fifth connector and the sixth connector are electrically connected to the fourth wiring layer, and the first connector, the second connector and the fifth connector are electrically connected to the battery management unit through wiring harnesses corresponding thereto, respectively. The second circuit board includes at least a third wiring layer, and the second battery module includes at least a fourth connector. The third battery module includes a third circuit board, and the third circuit board includes at least a fifth wiring layer and a sixth wiring layer. The third battery module includes at least a seventh connector, an eighth connector, and a ninth connector. Along a thickness direction of the third circuit board, the seventh connector is provided at one side of the third circuit board, and the eighth connector and the ninth connector are provided at the other side of the third circuit board. The seventh connector is electrically connected to the fifth wiring layer, and the eighth connector and the ninth connector are electrically connected to the sixth wiring layer. The seventh connector is electrically connected to the third connector through a wiring harness, so that a signal of the third battery module is transmitted to the battery management unit successively through the seventh connector, the third connector, and the second connector. The eighth connector is electrically connected to the sixth connector through a wiring harness, and the ninth connector is electrically connected to the fourth connector through a wiring harness, so that a signal of the second battery module is transmitted to the battery management unit successively through the fourth connector, the ninth connector, the eighth connector, the sixth connector and the fifth connector.

In one or more embodiments of the present disclosure, the circuit board further includes a substrate layer. Along a thickness direction of the battery pack, a wiring layer is provided on a surface of the substrate layer. A material of the wiring layer is copper foil, a thickness D1 of the wiring layer satisfies: 10 um≤D1≤35 um, and a thickness D2 of the substrate layer satisfies: 10 um≤D≤25 um.

In one or more embodiments of the present disclosure, along a thickness direction of the battery pack, a protective layer is provided on a surface of the wiring layer. The protective layer includes a polyimide film and an adhesive layer. The circuit board further includes a top layer and a bottom layer that are connected to the protective layer, and the top layer and the bottom layer are made of surface mount technology (SMT) adhesive. A thickness D3 of the protective layer satisfies: 30 um≤D3≤50 um.

It should be understood that the general description above and the detailed description in the following are merely illustrative, and cannot limit the present disclosure.

### BRIEF DESCRIPTION OF DRAWINGS

FIG. 1 is a structural schematic diagram of a battery pack according to one or more embodiments of the present disclosure;
FIG. 2 is a structural schematic diagram of a cells contact system and a battery management unit according to one or more embodiments of the present disclosure;
FIG. 3 is a structural schematic diagram of a cells contact system according to one or more embodiments of the present disclosure;
FIG. 4 is an enlarged partial view of portion A in FIG. 2;
FIG. 5 is an enlarged partial view of portion B in FIG. 2;
FIG. 6 is a schematic diagram illustrating the principle of signals being transmitted to the battery management unit through mutual transmission between battery modules in the battery pack, in which the battery pack includes a first battery module and a second battery module;
FIG. 7 is a schematic diagram illustrating the principle of signals being transmitted to the battery management unit through mutual transmission between battery modules in the battery pack, in which the battery pack includes a first battery module, a second battery module, and a third battery module;
FIG. 8 is a structural schematic diagram of a circuit board according to one or more embodiments of the present disclosure, in which the circuit board includes two wiring layers;
FIG. 9 is a structural schematic diagram of a circuit board according to one or more embodiments of the present disclosure, in which the circuit board includes one wiring layer; and
FIG. 10 is a structural schematic diagram of a circuit board according to one or more embodiments of the present disclosure, in which the circuit board includes three wiring layers.

### Reference signs:

1 - battery pack;
   11 - battery management unit;
   12 - first battery module;
      121- first cells contact system;
      1211 - first circuit board;
         1211a - first wiring layer;
         1211b - second wiring layer;
         1211c - fourth wiring layer;
      1212 - first connector;
      1213 - second connector;
      1214 - third connector;
      1215 - fifth connector;
      1216 - sixth connector;
   13 - battery cell;
   14 - second battery module;
      141- second cells contact system;
      1411 - second circuit board;
         1411a - third wiring layer;
      1412 - fourth circuit board;
   15 - third battery module;
      151 - third cells contact system;
         1511 - third circuit board;
            1511a - fifth wiring layer;
            1511b - sixth wiring layer;
         1512 - seventh connector;
         1513 - eighth connector;
         1514 - ninth connector;
      161 - substrate layer;
      162 - protective layer;
      163 - top layer;
      164 - bottom layer;
   17 - wire harness;
      181 - metal busbar;
      182 - thermistor;
   19 - partition.

The drawings are incorporated into the specification and form a part of this specification, illustrating embodiments consistent with the present disclosure, and are used together with the specification to explain the principles of the present disclosure.

### DESCRIPTION OF EMBODIMENTS

In order to better understand the technical solutions of the present disclosure, embodiments of the present disclosure are described in detail below in conjunction with the drawings.

It should be noted that, the described embodiments are only some rather than all of embodiments of the present disclosure. All other embodiments obtained by those skilled in the art without creative efforts according to embodiments of the present disclosure are within the protection scope of the present disclosure.

The terms used in embodiments of the present disclosure are only for the purpose of describing specific embodiments, and are not intended to limit the present disclosure. As used in embodiments of the present disclosure and the appended claims, the singular forms "a/an", "said", and "the" are intended to include the plural forms as well, unless the context clearly indicated otherwise.

It should be understood that the term "and/or" used herein is merely an association relationship describing an associated object, indicating that there may be three relationships, for example, A and/or B, and may indicate: A alone, both A and B, and B alone. In addition, the character "/" herein generally indicates that the related objects prior to and subsequent to the character present an "or" relationship.

It should be noted that the orientation terms such as "upper", "lower", "left", and "right" described in embodiments of the present disclosure are based on the perspective shown in the drawings and should not be construed as limiting the embodiments of the present disclosure. In addition, it should be understood in the context that when an element is described as being connected "on" or "under" another element, it can be directly connected "on" or "under" another element, or indirectly connected "on" or "under" another element through an intermediate element.

The battery pack is generally provided with a battery management unit (BMU). The BMU is configured as the core control module of the battery management system (BMS) and is responsible for monitoring, protecting and managing the operating status of the battery in real time. The battery cells of multiple modules in traditional battery packs are electrically connected to the battery management unit located at an end of the battery pack, which easily results in a messy arrangement of the wiring harness inside the battery pack and meanwhile, due to the messy arrangement of the wiring harness, increases the difficulty of assembly inside the battery pack, thereby greatly reducing the assembly efficiency of the battery.

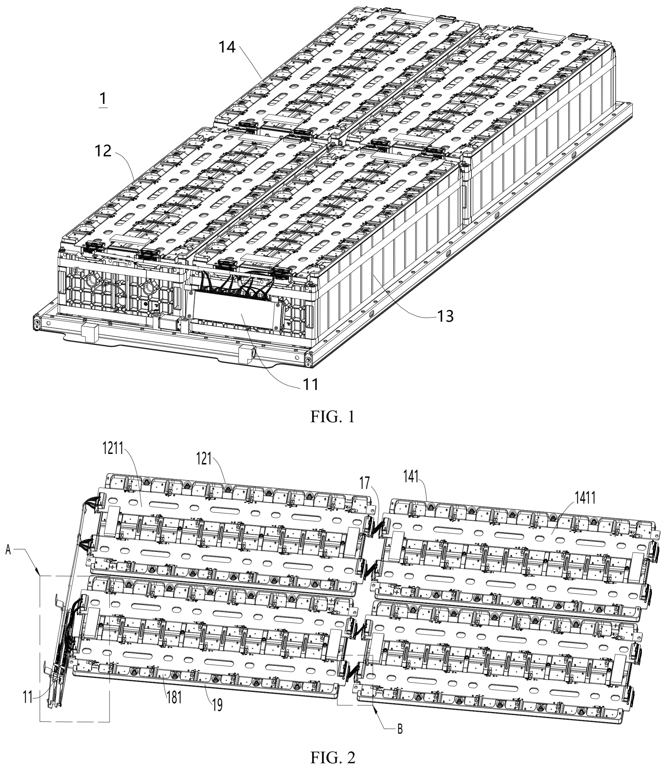

To solve the above problems, one or more embodiments of the present disclosure provide a battery pack 1, as shown in FIG. 1 to FIG. 3, and FIG. 8. The battery pack 1 includes at least two battery modules and a wiring harness 17 for electrically connecting the plurality of battery modules. The battery pack 1 further includes a battery management unit 11, and the at least two battery modules include a first battery module 12 directly electrically connected to the battery management unit 11.

The battery module includes a cells contact system (CCS) and battery cells 13 electrically connected to the cells contact system. The cells contact system includes a circuit board. The first battery module 12 includes a first circuit board 1211, and the first circuit board 1211 includes at least a first wiring layer 1211a and a second wiring layer 1211b. The first wiring layer 1211a is configured to transmit a signal of the first battery module 12 to the battery management unit 11, and the second wiring layer 1211b is electrically connected to other battery modules adjacent to the first battery module 12, so that signals from other battery modules adjacent to the first battery module 12 are transmitted to the battery management unit 11 through the second wiring layer 1211b.

The cells contact system further includes a partition 19 and metal busbars 181 electrically connected to the circuit board. The metal busbars 181 are copper buses or aluminum buses for electrically connecting to the battery cells 13. The partition 19 is primarily configured to isolate the metal busbars 181 or components with different potentials, thereby preventing short circuits and ensuring safe operation of the system. In addition, the partition 19 also provides a supporting function.

In one or more embodiments, the first battery module 12 is directly electrically connected to the battery management unit 11 through the wiring harness 17, that is, the first battery module 12 refers to the battery module with the shortest signal transmission distance to the battery management unit 11. The first battery module 12 includes at least a first wiring layer 1211a and a second wiring layer 1211b. During the operation of the battery pack 1, the first wiring layer 1211a is configured to collect and transmit status information of the first battery module 12, and the second wiring layer 1211b is electrically connected to other battery modules that are adjacent and directly connected to first battery module 12 through the wiring harness 17, so that the second wiring layer 1211b can collect and transmit status information of other battery modules that are adjacent and directly connected to the first battery module 12 through the wiring harness 17, and thus the status information of other battery modules that are adjacent and directly connected to the first battery module 12 through the wiring harness 17 can be transmitted to the battery management unit 11 through the first battery module 12.

The first battery module of the battery pack 1 is provided with at least two wiring layers, so that the battery pack 1 transmit signals successively from the battery module with a farthest signal transmission distance to the battery management unit toward the battery module with a closer signal transmission distance to the battery management unit 11, thereby transmitting the status information of the battery modules, except for the first battery module 12, to the battery management unit 11 one by one through wiring layers, except for the first wiring layer 1211a, in the first battery module 12. Such a design avoids the problem in the conventional battery pack in which multiple battery modules are individually connected to the battery management unit through wiring harnesses, facilitates reduction of the length of the wiring harnesses 17 used and optimization of the arrangement of the wiring harness 17 inside the battery pack 1, thereby improving the assembly efficiency inside the battery pack 1, reducing production costs, and improving the space utilization inside the battery pack 1.

In addition, the circuit board according to one or more embodiments of the present disclosure may be a flexible printed circuit (FPC) or a rigid printed circuit board (PCB).

In one or more embodiments, as shown in FIG. 1, FIG. 2, FIG. 8, and FIG. 10, the battery pack 1 includes n battery modules, where n≥2. The first circuit board 1211 includes n wiring layers arranged along the thickness direction thereof, where n may be 2, 3, 4, 5, 6, 7, 8, etc.

When the battery pack 1 includes two battery modules, the first circuit board 1211 includes two wiring layers arranged along the thickness direction thereof. When the battery pack 1 includes three battery modules, the first circuit board 1211 includes three wiring layers arranged along the thickness direction thereof. When the battery pack 1 includes four battery modules, the first circuit board 1211 includes four wiring layers arranged along the thickness direction thereof. Therefore, wiring layers corresponding to the battery modules in the battery pack 1 are provided within the first battery module 12, so that, along the signal transmission direction towards the battery management unit in the battery pack 1, the other battery modules, except for the first battery module 12, can be electrically connected to the wiring layers of the first battery module 12, except for the first wiring layer 1211a, in a one-to-one manner, thereby improving the feasibility of signal transmission from the other battery modules to the battery management unit 11 through the first battery module 12. Furthermore, the wiring layers are spaced apart from each other along the thickness direction of the first circuit board 1211, which reduces the risk of signal interference during signal transmission from the other battery modules through the first battery module 12, improves the reliability and accuracy of data transmission from the battery pack 1 to the battery management unit 11, and facilitates reducing the space occupied by the first circuit board 1211 along the length and width directions thereof, thereby further improving the space utilization inside the battery pack 1.

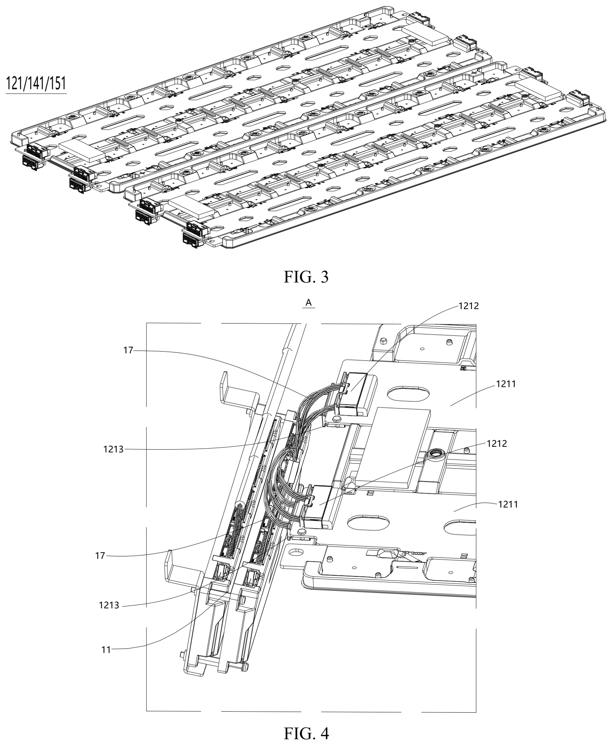

In one or more embodiments, as shown in FIG. 4 to FIG. 6, the cells contact system further includes connectors. The cells contact system of the first battery module 12 includes at least 2n-1 connectors, and each of the wiring layers of the first circuit board 1211 is electrically connected to at least one of the 2n-1 connectors.

In one or more embodiments, the connectors are configured to be connected to the wiring harnesses 17, so that the connectors can ensure communication and power transmission between the battery management unit 11 and the battery modules. For example, when n is 2, the cells contact system of the first battery module 12 includes at least three connectors. The first wiring layer 1211a is electrically connected to at least one connector, and this connector is electrically connected to the battery management unit 11 through the wiring harness 17, thereby improving the feasibility and reliability of sampling the first battery module 12 by the battery management unit 11. The second wiring layer 1211b is electrically connected to at least two connectors, one of which is electrically connected, through the wiring harness 17, to the battery module (in this embodiment, referring to another battery module adjacent to the first battery module 12) with the farthest signal transmission distance to the battery management unit, and the other of the two connectors is electrically connected to the battery management unit, thereby improving the feasibility and reliability of sampling, by the battery management unit 11, the battery module farthest from the battery management unit 11 in terms of signal transmission distance.

The cells contact system of the first battery module 12 includes at least 2n-1 connectors. The n wiring layers of the first circuit board 1211 are electrically connected to at least one of the 2n-1 connectors, respectively, so that each of the battery modules can be electrically connected to the battery management unit 11 through the wiring harnesses 17 and connectors via the first battery module 12, thereby enabling the signal transmition from the battery module with the farthest signal transmission distance to the battery management unit 11 towards the battery module closer to the battery management unit 11 successively, until the signals are transmitted to the battery management unit 11. That is, the first battery module 12 is provided with a plurality of wiring layers and connectors electrically connected to the wiring layers in a one-to-one manner, so that each battery module in the battery pack 1 transmit status information to the battery management unit 11 in a branched manner, thereby further improving the reliability and accuracy of data acquisition by the battery management unit 11 from each battery module. Furthermore, the wiring harnesses 17 are quickly plugged through the connectors, so that the wiring harnesses 17 are shortened, and consequently the resistance of the shorter line is smaller, resulting in more accurate and reliable sampling information.

In one or more embodiments, as shown in FIG. 2, and FIG. 6 to FIG. 8, each of the circuit boards of at least part of the at least two battery modules includes n wiring layers arranged along the thickness direction thereof. Each of the cells contact systems of at least part of the at least two battery modules includes at least 2n-1 connectors, and each of at least part of wiring layers of the circuit boards, except for the first circuit board 1211, is electrically connected to at least one of the 2n-1 connectors.

In some embodiments, the first battery module 12 includes a first cells contact system 121. The other battery modules, except for the first battery module 12, may include n wiring layers and 2n-1 connectors, and the manner in which the 2n-1 connectors are electrically connected to the corresponding n wiring layers in the battery modules, except for the first battery module 12, is the same as the manner in which the connectors are electrically connected to the wiring layers in the first battery module 12. That is, the structure of the cells contact systems in the other modules may be the same as the structure of the first cells contact system 121, so that they can be processed and assembled together during the production process, thereby improving production efficiency.

In one or more embodiments, as shown in FIG. 2 and FIG. 4 to FIG. 10, at least two battery modules further include a second battery module 14, and the second battery module 14 is electrically connected to the battery management unit 11 through all battery modules except for the second battery module 14. That is, the second battery module 14 refers to the battery module with the farthest signal transmission distance to the battery management unit 11.

A second circuit board 1411 of the second battery module 14 includes at least one wiring layer, and a cells contact system of the second battery module 14 includes at least one connector, the at least one connector is electrically connected to the at least one wiring layer. Along the signal transmission direction from the second battery module 14 to the battery management unit 11, the quantity of wiring layers of the circuit boards of the battery modules gradually increases, the quantity of connectors of the cells contact systems of the battery modules gradually increases, and at least part of the connectors of adjacent battery modules are electrically connected to each other.

In one or more embodiments, along the signal transmission direction from the second battery module 14 to the battery management unit 11, that is, the direction in which the signals are transmitted successively from the battery module located at the rear end to the battery module located at the front end, the quantity of wiring layers of the circuit boards of the battery modules gradually increases, so that the battery module located at the front end has sufficient wiring layers and connectors for electrical connection with the plurality of battery modules located at the rear end, thereby improving the feasibility and reliability of signal transmission from the second battery module 14 to the battery management unit 11 through the plurality of battery modules.

Along the signal transmission direction from the second battery module 14 to the battery management unit 11, as the quantity of wiring layers of adjacent battery modules increases by one, the quantity of connectors correspondingly increases by two, which is beneficial for saving material consumption and reducing the costs of the battery pack 1.

In one or more embodiments, as shown in FIG. 1 and FIG. 4 to FIG. 7, since the battery modules are arranged in sequence along the length direction of battery pack 1, all connector are located at the ends of the respective battery modules along the length direction of battery pack 1, so that the wiring harness 17 is connected between the connectors located at the ends, avoiding direct contact of the wiring harness 17 with the high-voltage, heat-generating components such as battery cells 13, which is beneficial for improving the safety and service life of the battery pack 1. Furthermore, locating the connectors at two ends of the battery module is beneficial for reducing the length of wiring harness 17 used to connect the two connectors, thereby reducing the costs and improving the space utilization inside the battery pack 1.

In addition, along the length direction of the battery pack 1, the plurality of connectors in the same battery module are arranged in a staggered manner, which reduces the risk of interference between the plurality of connectors of the same cells contact system during connector assembly, reduces the difficulty of assembly, and meanwhile, facilitates improving the firmness and stability of the connectors installed on the battery module, thereby improving the structural stability of the battery pack 1.

In one or more embodiments, as shown in FIG. 2 to FIG. 6 , FIG. 8, and FIG. 10, the battery pack 1 includes two battery modules, that is, when n is 2, the first battery module 12 includes at least a first connector 1212, a second connector 1213 and a third connector 1214. Along the thickness direction of the first circuit board 1211, the first connector 1212 is provided at one side of the first circuit board 1211, and the second connector 1213 and the third connector 1214 are provided at the other side of the first circuit board 1211. The first connector 1212 is electrically connected to the first wiring layer 1211a, and the second connector 1213 and the third connector 1214 are electrically connected to the second wiring layer 1211b. The first connector 1212 and the second connector 1213 are electrically connected to the battery management unit 11 through wiring harness 17 corresponding thereto, respectively.

The second battery module 14 includes a second cells contact system 141. The second circuit board 1411 includes at least a third wiring layer 1411a, and the second battery module 14 includes at least a fourth connector 1412. The third wiring layer 1411a is electrically connected to the fourth connector 1412, and the fourth connector 1412 is electrically connected to the third connector 1214 through the wiring harness 17, so that the signal of the second battery module 14 is transmitted to the battery management unit 11 successively through the fourth connector 1412, the third connector 1214 and the second connector 1213.

During the operation of the battery pack 1, the third wiring layer 1411a of the second battery module 14 collects the state information of the battery cells 13 in the second battery module 14 and converts it into a signal. The signal is transmitted from the fourth connector 1412 to the third connector 1214 through the wiring harness 17, then from the third connector 1214 to the second connector 1213 through the second wiring layer 1211b, and finally from the second connector 1213 to the battery management unit 11 through the wiring harness 17, thereby enabling the battery management unit 11 to sample the second battery module 14. Furthermore, the first wiring layer 1211a of the first battery module 12 collects the status information of the battery cells 13 in the first battery module 12 and converts it into a signal, so that the signal is transmitted from the first connector 1212 to the battery management unit 11 through the wiring harness 17, thereby enabling the battery management unit 11 to sample the first battery module 12. Such a design enables the sequential collection and output of the signals of the battery cells 13 in the battery module from the rear end to the front end, which is beneficial for optimizing the arrangement of the wiring harness 17 in the battery pack 1, and improving the neatness of the wiring, thereby improving the assembly efficiency inside the battery pack 1, reducing production costs, and improving the space utilization inside the battery pack 1.

In addition, the first connector 1212 is located on the upper surface of the first circuit board 1211, the second connector 1213 and the third connector 1214 are located on the lower surface of the first circuit board 1211, and the fourth connector 1412 is located on the upper surface of the second circuit board 1411, so that the user can electrically connect the connector on the upper surface of the second circuit board 1411 in the second battery module 14 located at the rear end to the connector on the lower surface of the first circuit board 1211 in the first battery module 12 located at the front end through the wiring harness 17, thereby enabling the user to quickly identify the wiring, and further improve the assembly efficiency of the battery pack 1.

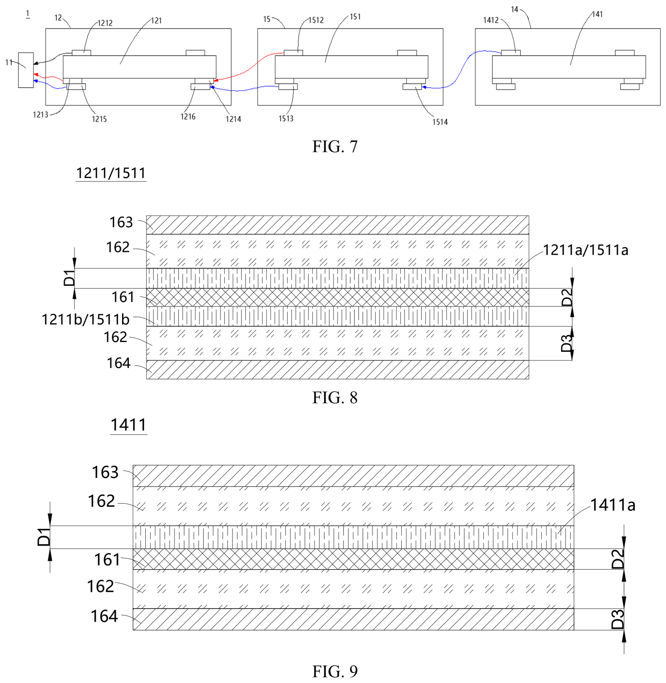

In one or more embodiments, as shown in FIG. 7 to FIG. 10, the battery pack 1 includes three battery modules, that is, when n is 3, a third battery module 15 that is electrically connected to the first battery module 12 and the second battery module 14 is provided between the first battery module 12 and the second battery module 14, so that the first battery module 12 and the second battery module 14 transmit signals through the third battery module 15. The first circuit board 1211 further includes a fourth wiring layer 1211c, and the first battery module 12 includes at least a first connector 1212, a second connector 1213, a third connector 1214, a fifth connector 1215 and a sixth connector 1216. Along the thickness direction of the first circuit board 1211, the first connector 1212 is provided at one side of the first circuit board 1211, the second connector 1213, the third connector 1214, the fifth connector 1215 and the sixth connector 1216 are provided at the other side of the first circuit board 1211. The first connector 1212 is electrically connected to the first wiring layer 1211a, the second connector 1213 and the third connector 1214 are electrically connected to the second wiring layer 1211b, the fifth connector 1215 and the sixth connector 1216 are electrically connected to the fourth wiring layer 1211c, and the first connector 1212, the second connector 1213 and the fifth connector 1215 are electrically connected to the battery management unit 11 through wiring harnesses 17 corresponding thereto, respectively.

The second circuit board 1411 includes at least a third wiring layer 1411a, and the second battery module 14 includes at least a fourth connector 1412.

The third battery module 15 includes a third cells contact system 151, which includes a third circuit board 1511. The third circuit board 1511 includes at least a fifth wiring layer 1511a and a sixth wiring layer 1511b. The third battery module 15 includes at least a seventh connector 1512, an eighth connector 1513 and a ninth connector 1514. Along the thickness direction of the third circuit board 1511, the seventh connector 1512 is provided at one side of the third circuit board 1511, and the eighth connector 1513 and the ninth connector 1514 are provided at the other side of the third circuit board 1511. The seventh connector 1512 is electrically connected to the fifth wiring layer 1511a, and the eighth connector 1513 and the ninth connector 1514 are electrically connected to the sixth wiring layer 1511b. The seventh connector 1512 is electrically connected to the third connector 1214 through the wiring harness 17, so that the signal of the third battery module 15 is transmitted to the battery management unit 11 successively through the seventh connector 1512, the third connector 1214 and the second connector 1213.

Furthermore, the eighth connector 1513 is electrically connected to the sixth connector 1216 through the wiring harness 17, and the ninth connector 1514 is electrically connected to the fourth connector 1412 through the wiring harness 17, so that the signal of the second battery module 14 is transmitted to the battery management unit 11 successively through the fourth connector 1412, the ninth connector 1514, the eighth connector 1513, the sixth connector 1216 and the fifth connector 1215.

During the operation of the battery pack 1, the third wiring layer 1411a of the second battery module 14 collects the status information of the battery cells 13 in the second battery module 14 and converts it into a signal. The signal is transmitted from the fourth connector 1412 to the ninth connector 1514 through the wiring harness 17, then from the ninth connector 1514 to the eighth connector 1513 through the sixth wiring layer 1511b, then from the eighth connector 1513 to the sixth connector 1216 through the wiring harness 17, then from the sixth connector 1216 to the fifth connector 1215 through the fourth wiring layer 1211c, and finally from the fifth connector 1215 to the battery management unit 11 through the wiring harness 17, thereby enabling the battery management unit 11 to sample the second battery module 14. Furthermore, the fifth wiring layer 1511a of the third battery module 15 collects the status information of the battery cells 13 in the third battery module 15 and converts it into a signal. The signal is transmitted from the seventh connector 1512 to the third connector 1214 through the wiring harness 17, then from the third connector 1214 to the second connector 1213 through the second wiring layer 1211b, and finally from the second connector 1213 to the battery management unit 11 through the wiring harness 17, thereby enabling the battery management unit 11 to sample the third battery module 15. Furthermore, the first wiring layer 1211a of the first battery module 12 collects the status information of the battery cells 13 in the first battery module 12 and converts it into a signal, so that the signal is transmitted from the first connector 1212 to the battery management unit 11 through the wiring harness 17, thereby enabling the battery management unit 11 to sample the first battery module 12.

In summary, providing a plurality of wiring layers on the circuit board and electrically connecting each battery module sequentially through the connector enables the sequential collection and output of the signals of the battery cells 13 in the battery module from the rear end to the front end, which is beneficial for optimizing the arrangement of the wiring harness 17 in the battery pack 1, and improving the neatness of the wiring, thereby improving the assembly efficiency inside the battery pack 1, reducing production costs, and improving the space utilization inside the battery pack 1.

In addition, in one or more embodiments, the fifth connector 1215, the sixth connector 1216, the eighth connector 1513, and the ninth connector 1514 are located at the same height along the height direction of the battery module, which is beneficial for reducing the length of the wiring harness 17 and the space occupied by the wiring harness 17 along the height direction of the battery module. Furthermore, such a design facilitates the user to perform layered wiring along the height direction, thereby improving the accuracy and convenience of wiring.

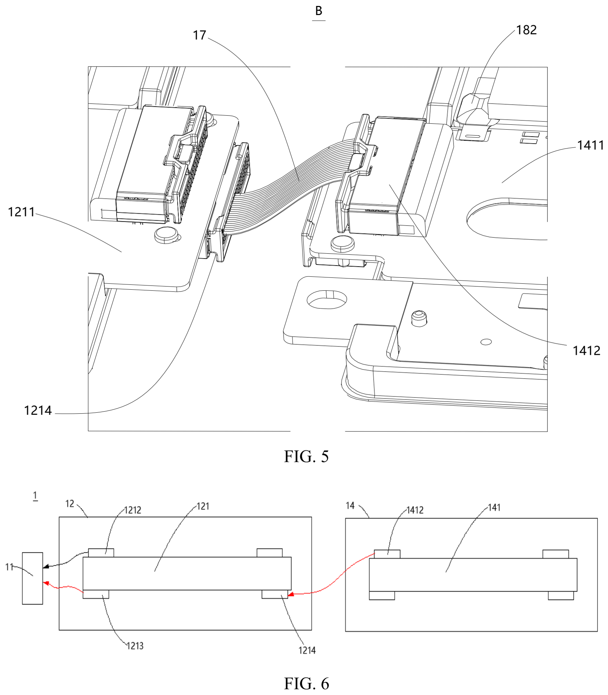

In addition, as shown in the embodiments of FIG. 6 and FIG. 7, the cells contact systems, except for the first cells contact system 121, may be configured to have the same quantity of wiring layers and connectors as the first cells contact system 121, which facilitates the centralized production of the cells contact systems. During assembly, the user only need to select wiring according to the actual quantity of battery modules provided in the battery pack 1, without adding steps for separately arranging the position and order of different battery modules, thereby improving the production efficiency of the battery pack 1.

In one or more embodiments, as shown in FIG. 8 to FIG. 10, the circuit board further includes a substrate layer 161. A wiring layer is provided on the surface of the substrate layer 161 along the thickness direction of the battery pack 1. The material of the wiring layer is copper foil, and the thickness D1 of the wiring layer satisfies: 10 um≤D1≤35 um, and the thickness D2 of the substrate layer 161 satisfies: 10 um≤D2≤25 um. D1 may be 10 um, 11 um, 12 um, 13 um, 14 um, 15 um, 16 um, 17 um, 18 um, 19 um, 20 um, 21 um, 22 um, 23 um, 24 um, 25 um, 26 um, 27 um, 28 um, 29 um, 30 um, 31 um, 32 um, 33 um, 34 um, 35 um, etc. D2 may be 10 um, 11 um, 12 um, 13 um, 14 um, 15 um, 16 um, 17 um, 18 um, 19 um, 20 um, 21 um, 22 um, 23 um, 24 um, 25 um, etc.

When D1 is too large, that is, when the wiring layer is too thick, the thickness of the circuit board significantly increases, which causes material waste. When D1 is too small, that is, when the wiring layer is too thin, the internal resistance of the wiring layer is too large, which is prone to the overheating of the circuit board and the risk of burning, thereby reducing the safety of the battery pack 1.

Therefore, by configuring D1 satisfy 10 um≤D1≤35 um, it is beneficial for improving the safety of the battery pack 1 without causing material waste.

When D2 is too large, that is, when the substrate layer 161 is too thick, the thickness of the circuit board significantly increases, which causes material waste. When D2 is too small, that is, when the substrate layer 161 is too thin, the internal resistance of the substrate layer 161 significantly increases, which is prone to the overheating of the circuit board and the risk of burning, thereby reducing the safety of the battery pack 1. Furthermore, the structural strength of the circuit is significantly reduced, which is prone to the risk of breakage.

Therefore, by configurating D2 satisfy 10 um≤D2≤25 um, it is beneficial for improving the safety of the battery pack 1, while ensuring that the structural strength of the circuit board is moderate without causing material waste.

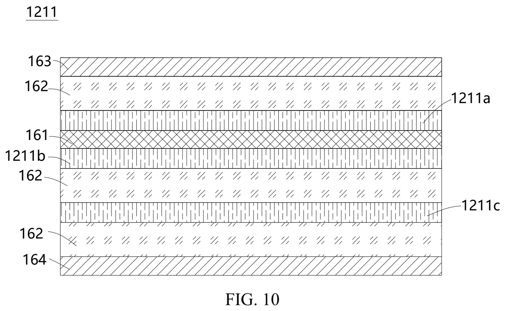

In one or more embodiments, as shown in FIG. 8 and FIG. 10, along the thickness direction of the battery pack 1, a protective layer 162 is provided on the surface of the wiring layer. The protective layer 162 includes a polyimide film (PI film) and an adhesive layer, so that the protective layer 162 has good dielectric properties. As a result, the protective layer 162 can be configured to isolate the plurality of wiring layers arranged along the thickness direction of the circuit board, so that the battery management system can collect information from different battery modules in a branched manner. The circuit board further includes a top layer 163 and a bottom layer 164 that are connected to the protective layer 162. The top layer 163 and the bottom layer 164 are SMT adhesives, which are mainly used to mount the surface mount devices (SMD) to the surface of the circuit board.

As shown in FIG. 8 to FIG. 10, the protective layer 162 is provided between a top layer 163 and the wiring layer, as well as between a bottom layer 164 and the wiring layer. Furthermore, as shown in FIG. 10, the protective layer 162 is provided between two adjacent wiring layers to improve the reliability and accuracy of sampling of the battery pack 1.

The thickness D3 of the protective layer 162 satisfies: 30 um≤D3≤50 um. D3 may be 30 um, 31 um, 32 um, 33 um, 34 um, 35 um, 36 um, 37 um, 38 um, 39 um, 40 um, 41 um, 42 um, 43 um, 44 um, 45 um, 46 um, 47 um, 48 um, 49 um, 50 um, etc.

When D3 is too large, that is, when the protective layer 162 is too thick, the thickness of the protective layer 162 significantly increases, which causes material waste. When D3 is too small, that is, when the protective layer 162 is too thin, the dielectric properties of the protective layer 162 are reduced, leading to the risk of short circuits in the circuit board, thereby greatly reducing the safety of use.

Therefore, by configuring D3 satisfy 30 um≤D3≤50 um, it is beneficial for improving the safety of the battery pack 1 without causing material waste.

In one or more embodiments, as shown in FIG. 5, the cells contact system further includes a plurality of thermistors 182 and a plurality of metal busbars 181. The metal busbars 181 are electrically connected to the circuit board through nickel sheets. The thermistors 182 can be provided on the nickel sheets. The thermistors 182 are configured to detect the temperature of the battery module and can provide overheat protection for the battery module, thereby further improving the safety of the battery pack 1.

The above description is merely implementations of the embodiments of the present disclosure, but the protection scope of the embodiments of the present disclosure is not limited thereto. Any modifications or substitutions within the technical scope disclosed in the embodiments of the present disclosure shall fall within the protection scope of the embodiments of the present disclosure. Therefore, the protection scope of the embodiments of the present disclosure should be determined by the protection scope of the claims.

## Claims

1. A battery pack, comprising:
at least two battery modules,
a wiring harness for electrically connecting the at least two battery modules, and
a battery management unit;
wherein the at least two battery modules comprises a first battery module directly electrically connected to the battery management unit; and
wherein at least one battery module comprises a cells contact system and battery cells electrically connected to the cells contact system, the cells contact system comprises a circuit board, the first battery module comprises a first circuit board, the first circuit board comprises at least a first wiring layer and a second wiring layer.

2. The battery pack according to claim 1, further comprising n battery modules, wherein n≥2, and the first circuit board comprises n wiring layers arranged along a thickness direction of the first circuit board.

3. The battery pack according to claim 2, wherein the cells contact system further comprises connectors, a cells contact system of the first battery module comprises at least 2n-1 connectors, and each of the wiring layers of the first circuit board is electrically connected to at least one of the 2n-1 connectors.

4. The battery pack according to claim 3, wherein each of circuit boards of at least part of the at least two battery modules comprises n wiring layers arranged along a thickness direction of the circuit boards, each of cells contact systems of at least part of the at least two battery modules comprises at least 2n-1 connectors, and each of at least part of wiring layers of other circuit boards except for the first circuit board is electrically connected to at least one of the 2n-1 connectors.

5. The battery pack according to claim 3, wherein
the at least two battery modules further comprises a second battery module, and the second battery module is electrically connected to the battery management unit through all battery modules except for the second battery module;
a second circuit board of the second battery module comprises at least one wiring layer, a cells contact system of the second battery module comprises at least one connector, and the at least one connector is electrically connected to the at least one wiring layer; and
along a signal transmission direction from the second battery module to the battery management unit, a quantity of wiring layers of circuit boards of all the battery modules gradually increases, a quantity of connectors of cells contact systems of all the battery module gradually increases, and at least part of connectors of adjacent battery modules are electrically connected to each other.

6. The battery pack according to claim 3, wherein
along a length direction of the battery pack, each of the connectors is provided at an end of each of the two battery modules; and
along the length direction of the battery pack, a plurality of connectors in a same battery module are arranged in a staggered manner.

7. The battery pack according to claim 5, comprising two battery modules, wherein
the first wiring layer is configured to transmit a signal of the first battery module to the battery management unit, and the second wiring layer is configured to be electrically connected to other battery modules adjacent to the first battery module, in such a manner that signals of other battery modules adjacent to the first battery module are transmitted to the battery management unit through the second wiring layer;
the first battery module comprises at least a first connector, a second connector, and a third connector, along the thickness direction of the first circuit board, the first connector is provided at one side of the first circuit board, the second connector and the third connector are provided at the other side of the first circuit board, the first connector is electrically connected to the first wiring layer, the second connector and the third connector are both electrically connected to the second wiring layer, and the first connector and the second connector are electrically connected to the battery management unit through wiring harnesses corresponding thereto, respectively; and
the second circuit board comprises at least a third wiring layer, the second battery module comprises at least a fourth connector, the third wiring layer is electrically connected to the fourth connector, the fourth connector is electrically connected to the third connector through the wiring harness, in such a manner that a signal of the second battery module is transmitted to the battery management unit successively through the fourth connector, the third connector and the second connector.

8. The battery pack according to claim 5, comprising three battery modules, wherein
a third battery module is provided between and electrically connected to the first battery module and the second battery module, in such a manner that the first battery module and the second battery module transmit signals through the third battery module, the first circuit board further comprises a fourth wiring layer, the first battery module comprises at least a first connector, a second connector, a third connector, a fifth connector and a sixth connector, along the thickness direction of the first circuit board, the first connector is provided at one side of the first circuit board, the second connector, the third connector, the fifth connector and the sixth connector are provided at the other side of the first circuit board, the first connector is electrically connected to the first wiring layer, the second connector and the third connector are both electrically connected to the second wiring layer, the fifth connector and the sixth connector are both electrically connected to the fourth wiring layer, and the first connector, the second connector and the fifth connector are electrically connected to the battery management unit through wiring harnesses corresponding thereto, respectively;
the second circuit board comprises at least a third wiring layer, and the second battery module comprises at least a fourth connector;
the third battery module comprises a third circuit board, the third circuit board comprises at least a fifth wiring layer and a sixth wiring layer, the third battery module comprises at least a seventh connector, an eighth connector, and a ninth connector, along a thickness direction of the third circuit board, the seventh connector is provided at one side of the third circuit board, the eighth connector and the ninth connector are provided at the other side of the third circuit board, the seventh connector is electrically connected to the fifth wiring layer, the eighth connector and the ninth connector are both electrically connected to the sixth wiring layer, and the seventh connector is electrically connected to the third connector through the wiring harness, in such a manner that a signal of the third battery module is transmitted to the battery management unit successively through the seventh connector, the third connector, and the second connector; and
the eighth connector is electrically connected to the sixth connector through the wiring harness, and the ninth connector is electrically connected to the fourth connector through the wiring harness, in such a manner that a signal of the second battery module is transmitted to the battery management unit successively through the fourth connector, the ninth connector, the eighth connector, the sixth connector and the fifth connector.

9. The battery pack according to any one of claims 1 to 8, wherein the circuit board further comprises a substrate layer, along a thickness direction of the battery pack, the wiring layer is provided on a surface of the substrate layer, the wiring layer is made of a material of copper foil, a thickness D1 of the wiring layer is in a range of 10 um≤D1≤35 um, and a thickness D2 of the substrate layer is in a range of 10 um≤D≤25 um.

10. The battery pack according to any one of claims 1 to 8, wherein
along a thickness direction of the battery pack, a protective layer is provided on a surface of the wiring layer, the protective layer comprises a polyimide film and an adhesive layer, the circuit board further comprises a top layer and a bottom layer that are connected to the protective layer, and the top layer and the bottom layer are made of surface mount technology (SMT) adhesive; and
a thickness D3 of the protective layer is in a range of 30 um≤D3≤50 um.

11. The battery pack according to claim 3, wherein the second wiring layer is electrically connected to at least two connectors, one of the at least two connectors is electrically connected, through the wiring harness, to a battery module with a farthest signal transmission distance to battery management unit, and the other one of the at least two connectors is electrically connected to the battery management unit.

12. The battery pack according to claim 4, wherein the first battery module comprises a first cells contact system, and quantities of wiring layers and connectors of other cells contact systems, except for the first cells contact system, are identical to a quantity of wiring layers and connectors in the first cells contact system.

13. The battery pack according to claim 4, wherein the first battery module comprises a first cells contact system, and structures of other cells contact systems, except for the first cells contact system, are identical to a structure of the first cells contact system.

14. The battery pack according to claim 1, wherein the cells contact system further comprises a partition and metal busbars electrically connected to the circuit board, and the partition is configured to isolate the metal busbars with different potentials.

15. The battery pack according to claim 1, wherein the cells contact system further comprises a plurality of metal busbars and a plurality of thermistors, the plurality of metal busbars are electrically connected to the circuit board through nickel sheets, the plurality of thermistors are provided on the nickel sheets and are configured to detect temperatures of the battery modules to provide overheat protection for the battery modules.

## Amended claims

### Amended claims in accordance with Rule 137(2) EPC.

1. A battery pack (1), comprising:
at least two battery modules,
a wiring harness (17) for electrically connecting the at least two battery modules, and
a battery management unit (11);
wherein the at least two battery modules comprises a first battery module (12) directly electrically connected to the battery management unit (11); and
wherein at least one battery module comprises a cells contact system and battery cells (13) electrically connected to the cells contact system, the cells contact system comprises a circuit board, the first battery module (12) comprises a first circuit board (1211), the first circuit board (1211) comprises at least a first wiring layer (1211a) and a second wiring layer (1211b), and the cells contact system further comprises connectors.

2. The battery pack (1) according to claim 1, further comprising n battery modules, wherein n≥2, and the first circuit board (1211) comprises n wiring layers arranged along a thickness direction of the first circuit board (1211).

3. The battery pack (1) according to claim 2, wherein a cells contact system of the first battery module (12) comprises at least 2n-1 connectors, and each of the wiring layers of the first circuit board (1211) is electrically connected to at least one of the 2n-1 connectors.

4. The battery pack (1) according to claim 3, wherein each of circuit boards of at least part of the at least two battery modules comprises n wiring layers arranged along a thickness direction of the circuit boards, each of cells contact systems of at least part of the at least two battery modules comprises at least 2n-1 connectors, and each of at least part of wiring layers of other circuit boards except for the first circuit board (1211) is electrically connected to at least one of the 2n-1 connectors.

5. The battery pack (1) according to claim 3, wherein
the at least two battery modules further comprises a second battery module (14), and the second battery module (14) is electrically connected to the battery management unit (11) through all battery modules except for the second battery module (14);
a second circuit board (1411) of the second battery module (14) comprises at least one wiring layer, a cells contact system of the second battery module (14) comprises at least one connector, and the at least one connector is electrically connected to the at least one wiring layer; and
along a signal transmission direction from the second battery module (14) to the battery management unit (11), a quantity of wiring layers of circuit boards of all the battery modules gradually increases, a quantity of connectors of cells contact systems of all the battery module gradually increases, and at least part of connectors of adjacent battery modules are electrically connected to each other.

6. The battery pack (1) according to claim 1, wherein
along a length direction of the battery pack (1), each of the connectors is provided at an end of each of the two battery modules; and
along the length direction of the battery pack (1), a plurality of connectors in a same battery module are arranged in a staggered manner.

7. The battery pack (1) according to claim 5, comprising two battery modules, wherein
the first wiring layer (1211a) is configured to transmit a signal of the first battery module (12) to the battery management unit (11), and the second wiring layer (1211b) is configured to be electrically connected to other battery modules adjacent to the first battery module (12), in such a manner that signals of other battery modules adjacent to the first battery module (12) are transmitted to the battery management unit (11) through the second wiring layer (1211b);
the first battery module (12) comprises at least a first connector (1212), a second connector (1213), and a third connector (1214), along the thickness direction of the first circuit board (1211), the first connector (1212) is provided at one side of the first circuit board (1211), the second connector (1213) and the third connector (1214) are provided at the other side of the first circuit board (1211), the first connector (1212) is electrically connected to the first wiring layer (1211a), the second connector (1213) and the third connector (1214) are both electrically connected to the second wiring layer (1211b), and the first connector (1212) and the second connector (1213) are electrically connected to the battery management unit (11) through wiring harnesses (17) corresponding thereto, respectively; and
the second circuit board (1411) comprises at least a third wiring layer (1411a), the second battery module (14) comprises at least a fourth connector (1412), the third wiring layer (1411a) is electrically connected to the fourth connector (1412), the fourth connector (1412) is electrically connected to the third connector (1214) through the wiring harness (17), in such a manner that a signal of the second battery module (14) is transmitted to the battery management unit (11) successively through the fourth connector (1412), the third connector (1214) and the second connector (1213).

8. The battery pack (1) according to claim 5, comprising three battery modules, wherein
a third battery module (15) is provided between and electrically connected to the first battery module (12) and the second battery module (14), in such a manner that the first battery module (12) and the second battery module (14) transmit signals through the third battery module (15), the first circuit board (1211) further comprises a fourth wiring layer (1211c), the first battery module (12) comprises at least a first connector (1212), a second connector (1213), a third connector (1214), a fifth connector (1215) and a sixth connector (1216), along the thickness direction of the first circuit board (1211), the first connector (1212) is provided at one side of the first circuit board (1211), the second connector (1213), the third connector (1214), the fifth connector (1215) and the sixth connector (1216) are provided at the other side of the first circuit board (1211), the first connector (1212) is electrically connected to the first wiring layer (1211a), the second connector (1213) and the third connector (1214) are both electrically connected to the second wiring layer (1211b), the fifth connector (1215) and the sixth connector (1216) are both electrically connected to the fourth wiring layer (1211c), and the first connector (1212), the second connector (1213) and the fifth connector (1215) are electrically connected to the battery management unit (11) through wiring harnesses (17) corresponding thereto, respectively;
the second circuit board (1411) comprises at least a third wiring layer (1411a), and the second battery module (14) comprises at least a fourth connector (1412);
the third battery module (15) comprises a third circuit board (1511), the third circuit board (1511) comprises at least a fifth wiring layer (1511a) and a sixth wiring layer (1511b), the third battery module (15) comprises at least a seventh connector (1512), an eighth connector (1513), and a ninth connector (1514), along a thickness direction of the third circuit board (1511), the seventh connector (1512) is provided at one side of the third circuit board (1511), the eighth connector (1513) and the ninth connector (1514) are provided at the other side of the third circuit board (1511), the seventh connector (1512) is electrically connected to the fifth wiring layer (1511a), the eighth connector (1513) and the ninth connector (1514) are both electrically connected to the sixth wiring layer (1511b), and the seventh connector (1512) is electrically connected to the third connector (1214) through the wiring harness (17), in such a manner that a signal of the third battery module (15) is transmitted to the battery management unit (11) successively through the seventh connector (1512), the third connector (1214), and the second connector (1213); and
the eighth connector (1513) is electrically connected to the sixth connector (1216) through the wiring harness (17), and the ninth connector (1514) is electrically connected to the fourth connector (1412) through the wiring harness (17), in such a manner that a signal of the second battery module (14) is transmitted to the battery management unit (11) successively through the fourth connector (1412), the ninth connector (1514), the eighth connector (1513), the sixth connector (1512) and the fifth connector (1215).

9. The battery pack (1) according to any one of claims 1 to 8, wherein the circuit board further comprises a substrate layer (161), along a thickness direction of the battery pack (1), the wiring layer is provided on a surface of the substrate layer (161), the wiring layer is made of a material of copper foil, a thickness D1 of the wiring layer is in a range of 10 um≤D1≤35 um, and a thickness D2 of the substrate layer (161) is in a range of 10 um≤D≤25 um.

10. The battery pack (1) according to any one of claims 1 to 8, wherein
along a thickness direction of the battery pack (1), a protective layer (162) is provided on a surface of the wiring layer, the protective layer (162) comprises a polyimide film and an adhesive layer, the circuit board further comprises a top layer (163) and a bottom layer (164) that are connected to the protective layer (162), and the top layer (163) and the bottom layer (164) are made of surface mount technology (SMT) adhesive; and
a thickness D3 of the protective layer (162) is in a range of 30 um≤D3≤50 um.

11. The battery pack (1) according to claim 3, wherein the second wiring layer (1211b) is electrically connected to at least two connectors, one of the at least two connectors is electrically connected, through the wiring harness (17), to a battery module with a farthest signal transmission distance to battery management unit (11), and the other one of the at least two connectors is electrically connected to the battery management unit (11).

12. The battery pack (1) according to claim 4, wherein the first battery module (11) comprises a first cells contact system (121), and quantities of wiring layers and connectors of other cells contact systems, except for the first cells contact system (121), are identical to a quantity of wiring layers and connectors in the first cells contact system (121).

13. The battery pack (1) according to claim 4, wherein the first battery module (11) comprises a first cells contact system (121), and structures of other cells contact systems, except for the first cells contact system (121), are identical to a structure of the first cells contact system (121).

14. The battery pack (1) according to claim 1, wherein the cells contact system further comprises a partition (19) and metal busbars (181) electrically connected to the circuit board, and the partition (19) is configured to isolate the metal busbars (181) with different potentials.

15. The battery pack (1) according to claim 1, wherein the cells contact system further comprises a plurality of metal busbars (181) and a plurality of thermistors (182), the plurality of metal busbars (181) are electrically connected to the circuit board through nickel sheets, the plurality of thermistors (182) are provided on the nickel sheets and are configured to detect temperatures of the battery modules to provide overheat protection for the battery modules.
